# EUROPEAN PATENT APPLICATION

(11) **EP 4 703 598 A1**
(43) Date of publication of application: **04.03.2026**
(21) Application number: 24795993.5
(22) Date of filing: 22.04.2024
(51) Int. Cl.: F16C 11/04, H04M 1/02, G06F 1/16

(54) **HINGE COMPONENT AND ELECTRONIC DEVICE**

(30) Priority: 28.04.2023 CN 202310475880
(71) Applicant: Vivo Mobile Communication Co., Ltd., Dongguan, Guangdong 523863 (CN)
(72) Inventor: YANG, Sicheng, Dongguan, Guangdong 523863 (CN)
(74) Representative: Lavoix
(86) International application number: PCT/CN2024/089055
(87) International publication number: WO 2024/222612

(57) **Abstract**

A hinge assembly (100) and an electronic device are provided. The hinge assembly (100) includes a base (10), a swing arm (20), and a hinge bracket (30). The hinge bracket (30) is disposed on the base (10), the swing arm (20) is rotatably connected to the hinge bracket (30), and in a process in which the swing arm (20) rotates relative to the hinge bracket (30), the hinge assembly (100) switches between an unfolded state and a folded state. There is a support surface (301) on a side that is of the hinge bracket (30) and that is away from the base (10), the support surface (301) is provided with a groove (3011), the groove (3011) includes a first groove part (30111) and a second groove part (30112), the first groove part (30111) is adjacent to the swing arm (20), and a size of the first groove part (30111) is greater than a size of the second groove part (30112).

## Description

### CROSS-REFERENCE

The present invention claims priority to Chinese Patent Application No. 202310475880.7, filed with the China National Intellectual Property Administration on April 28, 2023 and entitled "HINGE ASSEMBLY AND ELECTRONIC DEVICE", which is incorporated herein by reference in its entirety.

### TECHNICAL FIELD

This application pertains to the field of electronic technologies, and specifically, relates to a hinge assembly and an electronic device.

### BACKGROUND

**In** a related technology, a foldable electronic device is favored by users because of characteristics that large-screen display can be implemented during unfolding and occupied space is small during folding. The foldable electronic device includes a foldable flexible screen and a frame body rotatably connected through a hinge assembly. The flexible screen is driven to switch between an unfolded state and a folded state through rotation of the hinge assembly.

To further reduce space occupied by the foldable electronic device, a lightweight and thin foldable electronic device becomes a new development trend. Because a gap between the flexible screen and the hinge is further compressed, a folding form of the flexible screen gradually changes from an initial water-drop screen shape to a squeezed water-drop shape. This case causes a stress imprint problem in a folding area of the flexible screen. To be specific, in a folding process, the hinge assembly squeezes the flexible screen, and a squeezing force forms an indentation in a bending area of the flexible screen. This affects not only an overall appearance effect of the foldable electronic device but also a service life of the flexible screen.

### SUMMARY

This application is intended to provide a hinge assembly and an electronic device, to resolve a problem that an indentation is caused by squeezing a bending area of a flexible screen by a hinge assembly of a foldable electronic device.

To resolve the foregoing technical problem, this application is implemented as follows:

According to a first aspect, an embodiment of this application provides a hinge assembly, including a base, a swing arm, and a hinge bracket, where
the hinge bracket is disposed on the base, the swing arm is rotatably connected to the hinge bracket, and in a process in which the swing arm rotates relative to the hinge bracket, the hinge assembly switches between an unfolded state and a folded state; and
there is a support surface on a side that is of the hinge bracket and that is away from the base, the support surface is provided with a groove, the groove includes a first groove part and a second groove part, the first groove part is adjacent to the swing arm, and a size of the first groove part is greater than a size of the second groove part.

According to a second aspect, an embodiment of this application provides an electronic device, including a flexible screen, a first housing, a second housing, and the hinge assembly according to the first aspect, where
the first housing and the second housing are respectively rotatably connected to the hinge bracket through swing arms on two sides of the hinge bracket included in the hinge assembly, so that the electronic device is capable of switching between an unfolded state and a folded state; and
the flexible screen is disposed on a side of the first housing and the second housing, the flexible screen includes a bending area, the bending area is opposite to the hinge bracket, and the support surface of the hinge bracket is configured to support the bending area.

In the embodiments of this application, the hinge assembly is used for the foldable electronic device. When the electronic device is in the folded state, because the first groove part is adjacent to the swing arm, a bottom part of the first groove part may be arched toward the display screen and deformed and the bottom part of the first groove part exactly abuts against an end surface of the display screen due to a force provided by the swing arm and a thinner groove wall of the first groove part relative to a second groove part. In this way, the bottom part of the first groove part can provide a support function for the display screen without squeezing the display screen, so that occurrence of an indentation on the display screen is reduced, and a service life of the foldable electronic device is prolonged.

Additional aspects and advantages of this application are partially provided in the following descriptions, and partially become clear from the following descriptions, or are learned from practice of this application.

### BRIEF DESCRIPTION OF DRAWINGS

The foregoing and/or additional aspects and advantages of this application become clear and easy to understand from the description of embodiments in conjunction with the following accompanying drawings.
FIG. 1A is a schematic diagram of a structure of a hinge assembly in a related technology;
FIG. 1B is a schematic diagram of a structure of a cross-section A-A in FIG. 1A;
FIG. 1C is a schematic diagram of a structure of a cross-section B-B in FIG. 1A;
FIG. 1D is a schematic diagram of a structure of a cross-section C-C in FIG. 1A;
FIG. 2 is a schematic diagram of a structure of a hinge bracket according to an embodiment of this application;
FIG. 3 is a schematic diagram of a structure of a cross-section A-A in FIG. 2 according to an embodiment of this application;
FIG. 4 is a schematic diagram of a structure of a cross-section B-B in FIG. 2 according to an embodiment of this application;
FIG. 5 is a schematic diagram of a structure of a cross-section C-C in FIG. 2 according to an embodiment of this application;
FIG. 6 is a schematic diagram of a structure of a hinge assembly according to an embodiment of this application;
FIG. 7 is an enlarged schematic diagram of a structure of an area A1 in FIG. 6 according to an embodiment of this application; and
FIG. 8 is an enlarged schematic diagram of a structure of an area A2 in FIG. 6 according to an embodiment of this application.

### DESCRIPTION OF EMBODIMENTS

The following describes in detail embodiments of this application, and examples of the embodiments are shown in the accompanying drawings. Throughout the accompanying drawings, identical or similar reference numerals represent identical or similar elements or elements having identical or similar functions. Embodiments described below with reference to the accompanying drawings are examples and are intended to explain this application only, but are not construed as a limitation on this application. All other embodiments obtained by a person of ordinary skill in the art based on the embodiments of this application without creative efforts shall fall within the protection scope of this application.

Features of the terms "first" and "second" in the specification and claims of this application may explicitly or implicitly include one or more such features. In the descriptions of this application, unless otherwise stated, "a plurality of" means two or more than two. In addition, in the specification and claims, "and/or" represents at least one of the connected objects, and the character "/" usually represents an "or" relationship between associated objects.

In a related technology, a foldable electronic device includes a first housing, a second housing, a hinge assembly, and a flexible screen. The first housing and the second housing are rotatably connected to two sides of the hinge assembly, so that the electronic device is capable of switching between an unfolded state and a folded state. The flexible screen covers the first housing and the second housing, and bends as the electronic device is unfolded and folded. A bending area of the flexible screen is opposite to the hinge assembly. The hinge assembly includes a hinge bracket, and the hinge bracket may form a support for the bending area of the flexible screen.

A hinge assembly 100 includes a base 10, a swing arm 20, and a hinge bracket 30. The hinge bracket 30 is disposed on the base 10, the swing arm 20 is rotatably connected to the hinge bracket 30, and in a process in which the swing arm 20 rotates relative to the hinge bracket 30, the hinge assembly 100 switches between an unfolded state and a folded state.

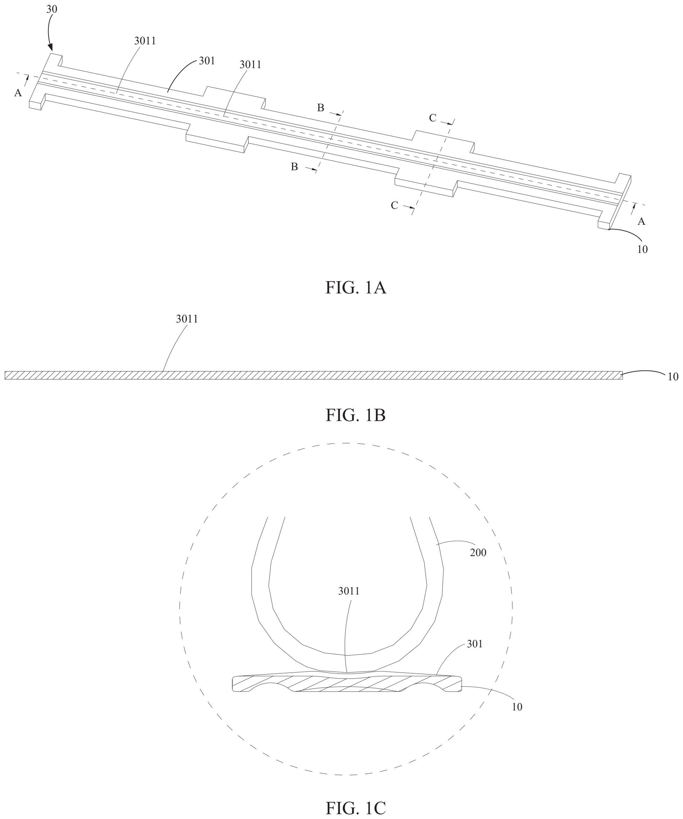

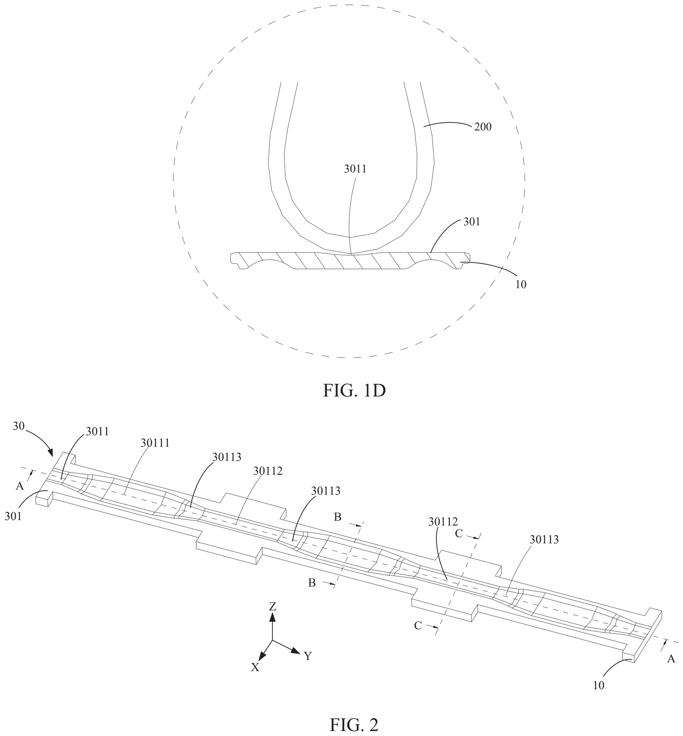

Schematic diagrams of a structure of the hinge bracket in the related technology are shown in FIG. 1A to FIG. 1D. FIG. 1B may be understood as a schematic diagram of a structure of a cross-section A-A in FIG. 1A. FIG. 1C may be understood as a schematic diagram of a structure of a cross-section B-B in FIG. 1A. FIG. 1D may be understood as a schematic diagram of a structure of a cross-section C-C in FIG. 1A.

As shown in FIG. 1A, there is a support surface 301 on a side that is of the hinge bracket 30 and that is away from the base 10, the support surface 301 is provided with a groove 3011, and an extension direction of the groove 3011 is a rotation axis direction of the hinge assembly. Referring to FIG. 1B, sizes of all locations of the groove 3011 are the same. Because a groove wall of a location that is in the groove 3011 and that is adjacent to the swing arm 20 is thinner than a groove wall of a location that is in the groove 3011 and that is not adjacent to the swing arm 20, under an acting force provided by the swing arm 20, a deformation amount of the location that is in the groove 3011 and that is adjacent to the swing arm 20 is greater than a deformation amount of the location that is in the groove 3011 and that is not adjacent to the swing arm 20. Referring to FIG. 1C, a deformation area of the location that is in the groove 3011 and that is adjacent to the swing arm 20 squeezes a display screen 200, causing a partial area of the display screen 200 to be pushed upward. Consequently, a stress imprint problem occurs on the display screen 200, and further, an indentation occurs on the display screen 200.

It should be noted that referring to FIG. 1D, because the deformation amount of the location that is in the groove 3011 and that is not adjacent to the swing arm 20 is less than the deformation amount of the location that is in the groove 3011 and that is adjacent to the swing arm 20, the location that is in the groove 3011 and that is not adjacent to the swing arm 20 does not squeeze the display screen 200, and does not cause a stress imprint problem on the display screen 200. It can be learned that the hinge assembly of the currently foldable electronic device tends to squeeze the bending area of the flexible screen, causing poor use performance of the foldable electronic device.

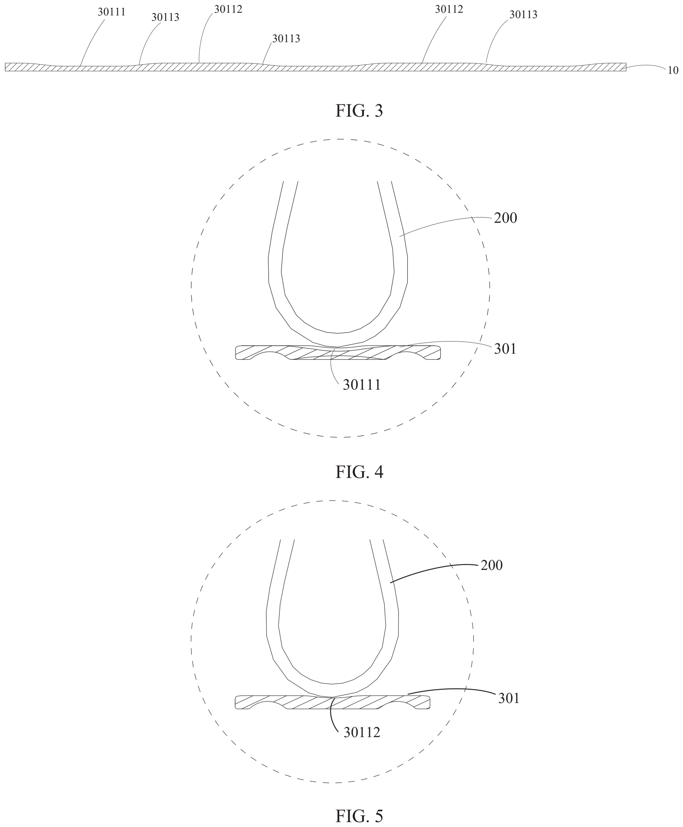

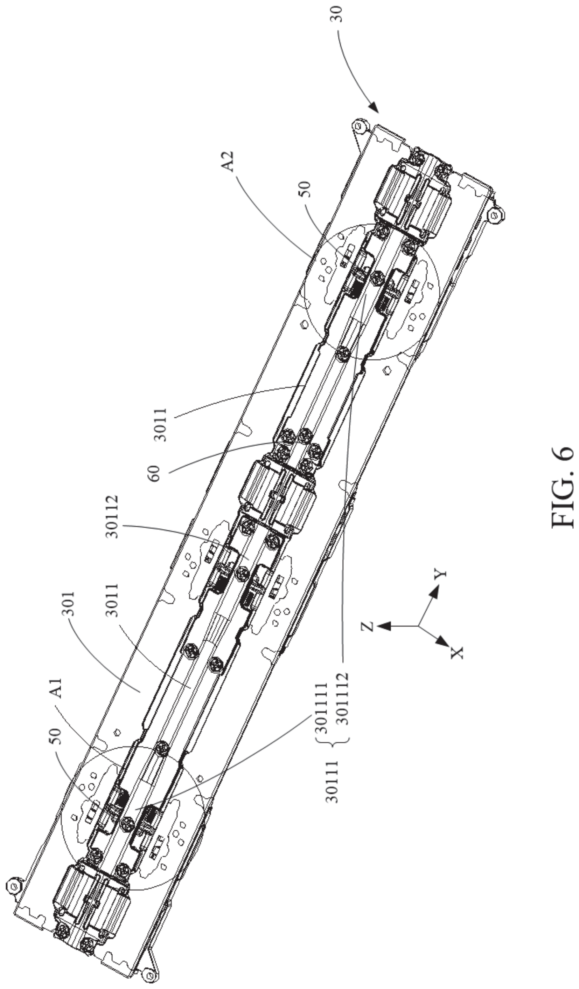

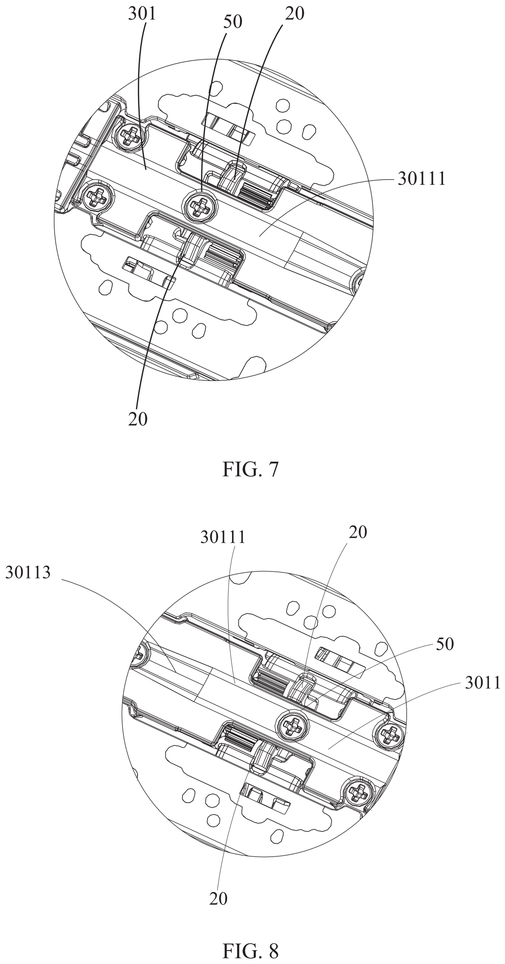

A hinge assembly provided in the embodiments of this application is shown in FIG. 2 to FIG. 8. FIG. 2 is a schematic diagram of a structure of a hinge assembly according to an embodiment of this application. FIG. 3 may be understood as a schematic diagram of a structure of a cross-section A-A in FIG. 2. FIG. 4 may be understood as a schematic diagram of a structure of a cross-section B-B in FIG. 2. FIG. 5 may be understood as a schematic diagram of a structure of a cross-section C-C in FIG. 2. FIG. 6 is a schematic diagram of a structure of another hinge assembly according to an embodiment of this application. FIG. 7 may be understood as an enlarged schematic diagram of a structure of an area A1 in FIG. 6. FIG. 8 may be understood as an enlarged schematic diagram of a structure of an area A2 in FIG. 6.

As shown in FIG. 2 to FIG. 8, a hinge assembly 100 includes a base 10, a swing arm 20, and a hinge bracket 30. The hinge bracket 30 is disposed on the base 10, the swing arm 20 is rotatably connected to the hinge bracket 30, and in a process in which the swing arm 20 rotates relative to the hinge bracket 30, the hinge assembly 100 switches between an unfolded state and a folded state.

There is a support surface 301 on a side that is of the hinge bracket 30 and that is away from the base 10, the support surface 301 is provided with a groove 3011, the groove 3011 includes a first groove part 30111 and a second groove part 30112, the first groove part 30111 is adjacent to the swing arm 20, and a size of the first groove part 30111 is greater than a size of the second groove part 30112. It may be understood that, that the first groove part 30111 is adjacent to the swing arm 20 means that in an extension direction of the groove 3011, the first groove part 30111 is opposite to the swing arm 20, in other words, a groove 3011 corresponding to a location that is on the hinge bracket 30 and that is rotatably connected to the swing arm 20 is the first groove part 30111, and a groove size at the location is greater than a groove size at another location.

It may be understood that the groove 3011 corresponding to the location that is on the hinge bracket 30 and that is rotatably connected to the swing arm 20 may also be understood as a location that is in the groove 3011 and that is adjacent to the swing arm 20, and the location that is in the groove 3011 and that is adjacent to the swing arm 20 may be referred to as the first groove part 30111 in this embodiment. A groove 3011 corresponding to a location that is on the hinge bracket 30 and that is not rotatably connected to the swing arm 20 may also be understood as a location that is in the groove 3011 and that is not adjacent to the swing arm 20, and the location that is in the groove 3011 and that is not adjacent to the swing arm 20 may be referred to as the second groove part 30112 in this embodiment.

For a working principle of this embodiment of this application, refer to the following descriptions:
When the hinge assembly 100 is used with a display screen 200, in other words, the hinge assembly 100 is used for a foldable electronic device, when the electronic device is in a folded state, because the first groove part 30111 is adjacent to the swing arm 20, referring to FIG. 4, a bottom part of the first groove part 30111 may be arched toward the display screen 200 and deformed and the bottom part of the first groove part 30111 exactly abuts against an end surface of the display screen 200 due to a force provided by the swing arm 20 and a thinner groove wall of the first groove part 30111 relative to the second groove part 30112. In this way, the bottom part of the first groove part 30111 can provide a support function for the display screen 200 without squeezing the display screen 200, so that occurrence of an indentation on the display screen 200 is reduced, and a service life of the foldable electronic device is prolonged, in other words, an effect of using the hinge assembly 100 can be improved.

Because the existence of the swing arm 20 causes inevitable deformation of the first groove part 30111, and deformation amounts of the first groove part 30111 and the second groove part 30112 are different, the size of the first groove part 30111 may be made different from the size of the second groove part 30112, and the size of the first groove part 30111 may be made greater than the size of the second groove part 30112, in other words, corresponding sizes are selected based on different locations of the first groove part 30111 and the second groove part 30112, so that after the first groove part 30111 and the second groove part 30112 are deformed, neither the bottom part of the first groove part 30111 nor a bottom part of the second groove part 30112 squeezes the display screen 200, thereby avoiding occurrence of an indentation on the display screen 200. In other words, in this embodiment of this application, it is found that the deformation amounts of the first groove part 30111 and the second groove part 30112 are different, and structures of the first groove part 30111 and the second groove part 30112 are adjusted, so that no indentation occurs on the display screen 200. In addition, the first groove part 30111 and the second groove part 30112 can exactly provide a support function for the display screen 200, so that an effect of supporting the display screen 200 is improved.

For example, in a case that the swing arm 20 rotates relative to the hinge bracket 30 and the hinge assembly 100 is in the folded state, the bottom part of the first groove part 30111 abuts against the end surface of the display screen 200, so that the bottom part of the first groove part 30111 can provide the support function for the display screen 200.

It should be noted that when the bottom part of the first groove part 30111 abuts against the end surface of the display screen 200, the bottom part of the first groove part 30111 may be further located on a same plane as an area other than the first groove part 30111 and the second groove part 30112 on the support surface 301. In this way, the effect of supporting the display screen 200 can be further improved.

It should be noted that referring to FIG. 4, when the hinge assembly 100 is in the folded state, the display screen 200 is also in a folded state, and the display screen 200 may be shaped in a water drop. A lowest portion of the water drop may be the end surface of the display screen 200. The end surface may also be referred to as an end part. The bottom part of the first groove part 30111 abuts against the end surface of the display screen 200, so that the support surface (the support surface may be understood as a plane on which the bottom part of the first groove part 30111 is located) for the end surface of the display screen 200 can reach a relatively consistent height, and forces exerted on a bottom part of the water drop are relatively uniform to reduce stress concentration cases of the display screen 200, thereby effectively resolving a problem of uneven indentations of the display screen 200 and improving an effect of using the hinge assembly 100 and the display screen 200.

In an optional implementation, referring to FIG. 2, a width of the first groove part 30111 in a first direction is greater than a width of the second groove part 30112 in the first direction, and the first direction is a direction of a connecting line between the first groove part 30111 and the swing arm 20.

The first direction may be understood as an X direction in FIG. 2 and FIG. 6.

In an implementation of this application, the width of the first groove part 30111 in the first direction is greater than the width of the second groove part 30112 in the first direction. Compared with a manner in which the widths of the first groove part 30111 and the second groove part 30112 in the first direction are the same, this equivalently increases the width of the first groove part 30111, and therefore, can reduce the deformation amount of the bottom part of the first groove part 30111. In this way, squeezing the display screen 200 by the bottom part of the first groove part 30111 can be reduced, so that occurrence of an indentation on the display screen 200 is reduced, and an effect of using the display screen 200 can be improved.

In an optional implementation, referring to FIG. 3, a depth of the first groove part 30111 in a second direction is greater than a depth of the second groove part 30112 in the second direction, the second direction is a direction separately perpendicular to the first direction and a third direction, and the third direction is a direction of a connecting line between the first groove part 30111 and the second groove part 30112.

The second direction may be understood as a Z direction in FIG. 2 and FIG. 6, and the third direction may be understood as a Y direction in FIG. 2 and FIG. 6. The third direction may also be referred to as a length direction of the first groove part 30111 and the second groove part 30112.

In an implementation of this application, the depth of the first groove part 30111 in the second direction is greater than the depth of the second groove part 30112 in the second direction. Compared with a manner in which the depths of the first groove part 30111 and the second groove part 30112 are the same, this equivalently increases the depth of the first groove part 30111, and therefore, can reduce the deformation amount of the bottom part of the first groove part 30111. In this way, squeezing the display screen 200 by the bottom part of the first groove part 30111 can be reduced, so that occurrence of an indentation on the display screen 200 is reduced, and the effect of using the display screen 200 can be improved.

It should be noted that compared with the foregoing manner of increasing the width of the first groove part 30111, increasing the depth of the first groove part 30111 can simplify a processing manner of the first groove part 30111 and improve processing efficiency.

In an optional implementation, referring to FIG. 2 and FIG. 3, the groove 3011 further includes a third groove part 30113, the first groove part 30111 and the second groove part 30112 communicate with each other through the third groove part 30113, a size of the third groove part 30113 is less than the size of the first groove part 30111, and the size of the third groove part 30113 is greater than the size of the second groove part 30112.

In an implementation of this application, the first groove part 30111 and the second groove part 30112 communicate with each other through the third groove part 30113, the size of the third groove part 30113 is less than the size of the first groove part 30111, and the size of the third groove part 30113 is greater than the size of the second groove part 30112. In this way, the sizes can sequentially decrease in a direction of the first groove part 30111, the third groove part 30113, and the second groove part 30112, so that the following phenomena are reduced: because of a sudden change between the sizes of the first groove part 30111 and the second groove part 30112, the deformation amounts of the first groove part 30111 and the second groove part 30112 suddenly change, and strength of different locations of the hinge assembly 100 suddenly changes. In other words, change values of the strength of the different locations of the hinge assembly 100 are relatively uniform.

In an optional implementation, the third groove part 30113 includes a first location in communication with the first groove part 30111 and a second location in communication with the second groove part 30112, and the size of the third groove part 30113 gradually decreases in a direction from the first location to the second location.

A manner in which the size of the third groove part 30113 gradually decreases is not limited herein. For example, in the direction from the first location to the second location, a first target location point, a second target location point, and a third target location point are included, a distance between the first target location point and the second target location point is equal to a distance between the second target location point and the third target location point, and a size difference between the first target location point and the second target location point is also equal to a size difference between the second target location point and the third target location point.

In an implementation of this application, the size of the third groove part 30113 gradually decreases in the direction from the first location to the second location. In this way, uniformity of the change values of the strength of the different locations of the hinge assembly 100 can be further improved, and in addition, a linear transition effect of supporting the display screen 200 can be further ensured.

In an optional implementation, the size of the third groove part 30113 includes a width and a depth, the width is a width in a first direction, the first direction is a direction of a connecting line between the first groove part 30111 and the swing arm 20, the depth is a depth in a second direction, the second direction is a direction separately perpendicular to the first direction and a third direction, and the third direction is a direction of a connecting line between the first groove part 30111 and the second groove part 30112.

In an implementation of this application, both the width and the depth of the third groove part 30113 gradually decrease in the direction from the first location to the second location. In this way, uniformity of the change values of the strength of the different locations of the hinge assembly 100 can be further improved, and in addition, it can be further ensured that the linear transition effect of supporting the display screen 200 is better.

In an optional implementation, a sidewall of the first groove part 30111 and a sidewall of the second groove part 30112 each are a plane, and a sidewall of the third groove part 30113 is an arc-shaped surface.

In an implementation of this application, the sidewall of the first groove part 30111 and the sidewall of the second groove part 30112 each are a plane, the sidewall of the third groove part 30113 is an arc-shaped surface, and the size of the first groove part 30111 is greater than the size of the second groove part 30112. In this way, strength gradually changes from a location of the first groove part 30111 to a location of the third groove part 30113 and then to a location of the second groove part 30112, to avoid a phenomenon that a sidewall of the groove 3011 is prone to damage due to a sharp strength change, thereby prolonging a service life of the groove 3011.

In an optional implementation, referring to FIG. 6, a first through hole 50 for mounting a first screw is disposed in the first groove part 30111 and at a location that is of the first groove part 30111 and that is adjacent to the swing arm 20; and a second through hole 60 for mounting a second screw is disposed in the third groove part 30113 and at a location that is of the third groove part 30113 and that is connected to the second groove part 30112.

Sizes of the first through hole 50 and the second through hole 60 may be the same or different. This is not specifically limited herein.

In an implementation of this application, because the first through hole 50 and the second through hole 60 are disposed, when the first screw is mounted in the first through hole 50, and the second screw is mounted in the second through hole 60, an effect of fastening the hinge bracket 30 can be improved.

It should be noted that specific arrangement locations and a specific quantity of through holes for mounting a screw are not limited herein. For example, a through hole for mounting a screw may also be disposed in the second groove part 30112, or a through hole for mounting a screw may be disposed at a location other than the first groove part 30111, the second groove part 30112, and the third groove part 30113 in the groove 3011. In addition, a through hole for mounting a screw may also be disposed on the support surface 301.

In addition, optionally, a positioning hole may be further disposed in an area that is on the support surface 301 and in which no groove 3011 is disposed and at a location adjacent to the first groove part 30111, to facilitate positioning of the first groove part 30111 and the swing arm 20, and improve positioning efficiency and accuracy.

In an optional implementation, referring to FIG. 6, the first groove part 30111 includes a first target groove part 301111 and a second target groove part 301112 that are spaced apart, and the second groove part 30112 is located between the first target groove part 301111 and the second target groove part 301112.

A quantity of first target groove parts 301111 and a quantity of second target groove parts 301112 are not limited herein. For example, the first target groove part 301111, the second target groove part 301112, and a second groove part 30112 between the first target groove part 301111 and the second target groove part 301112 may constitute a groove group, and the groove 3011 may include a plurality of groove groups.

It should be noted that a first distance between the first target groove part 301111 and the second groove part 30112 may be equal to a second distance between the second target groove part 301112 and the second groove part 30112, in other words, the first target groove part 301111, the second groove part 30112, and the second target groove part 301112 may be equally spaced.

In an implementation of this application, the first groove part 30111 includes the first target groove part 301111 and the second target groove part 301112 that are spaced apart. In this way, sizes of the first target groove part 301111 and the second target groove part 301112 can be increased, to reduce indentation phenomena of locations on the display screen 200 that correspond to the first target groove part 301111 and the second target groove part 301112. In addition, because both the first target groove part 301111 and the second target groove part 301112 can support the display screen 200, the effect of supporting the display screen 200 is further improved.

An embodiment of this application further provides an electronic device, including a flexible screen, a first housing, a second housing, and the hinge assembly 100 in the foregoing embodiment.

The first housing and the second housing are respectively rotatably connected to the hinge bracket 30 through swing arms 20 on two sides of the hinge bracket 30 included in the hinge assembly 100, so that the electronic device is capable of switching between an unfolded state and a folded state.

The flexible screen is disposed on a side of the first housing and the second housing, the flexible screen includes a bending area, the bending area is opposite to the hinge bracket 30, and the support surface 301 of the hinge bracket 30 is configured to support the bending area.

The electronic device in this embodiment of this application may be referred to as a foldable electronic device, and the first housing and the second housing may be respectively understood as two housings of the electronic device that are capable of folding relative to each other. The first housing and the second housing may be connected to each other through the hinge assembly 100, and may switch between an unfolded state and a folded state by using the hinge assembly 100.

The flexible screen may include a first display area, the bending area, and a second display area. The first display area and the second display area are connected to each other through the bending area, and the bending area may be disposed opposite to the hinge bracket 30.

It should be noted that the flexible screen in this embodiment of this application may be understood as the display screen 200 in the foregoing embodiment.

In an optional implementation, when the electronic device is in the folded state, the first groove part 30111 is in a deformed state, and the flexible screen is closely fitted with a groove wall of the first groove part 30111. In this way, the groove wall of the first groove part 30111 can provide a support function for the flexible screen.

It should be noted that the groove wall of the first groove part 30111 may be understood as a bottom wall of the first groove part 30111.

The electronic device in this embodiment of this application includes the hinge assembly 100 in the foregoing embodiment, and therefore, has the same technical effect as in the foregoing embodiment. For a specific structure of the hinge assembly 100, refer to corresponding descriptions in the foregoing embodiment. Details are not described herein again.

The electronic device in this embodiment of this application includes the hinge assembly 100, including the base 10, the swing arm 20, and the hinge bracket 30. The hinge bracket 30 is disposed on the base 10, the swing arm 20 is rotatably connected to the hinge bracket 30, and in the process in which the swing arm 20 rotates relative to the hinge bracket 30, the hinge assembly 100 switches between the unfolded state and the folded state. There is the support surface 301 on the side that is of the hinge bracket 30 and that is away from the base 10, the support surface 301 is provided with the groove 3011, the groove 3011 includes the first groove part 30111 and the second groove part 30112, the first groove part 30111 is adjacent to the swing arm 20, and the size of the first groove part 30111 is greater than the size of the second groove part 30112.

In this way, because the support surface 301 of the hinge bracket 30 is configured to support the bending area, and a size of the location that is in the groove 3011 and that is adjacent to the swing arm 20 is relatively large, the deformation amount of the location can be reduced, so that an area obtained after the location is deformed exactly abuts against the bending area without squeezing the bending area which otherwise causes a stress imprint problem on the bending area.

A size of the location that is in the groove 3011 and that is not adjacent to the swing arm 20 is less than the size of the location that is in the groove 3011 and that is adjacent to the swing arm 20. However, a groove wall of an area in which the location that is in the groove 3011 and that is not adjacent to the swing arm 20 is located is relatively thick, and is less affected by an acting force of the swing arm 20. Therefore, the area does not squeeze the bending area, and does not cause a stress imprint problem on the bending area, and therefore, no waviness phenomenon occurs on the bending area, so that use performance and aesthetics of the bending area of the flexible screen are improved.

In this embodiment of this application, because hardness of the flexible screen is relatively small, when the electronic device is in the folded state, and a conventional hinge assembly is arched toward the flexible screen and deformed, the flexible screen tends to be squeezed, and an indentation tends to occur on the flexible screen, reducing a service life of the flexible screen and affecting aesthetics of the flexible screen. Using the hinge assembly 100 in this embodiment can reduce occurrence of an indentation problem of the flexible screen, to prolong a service life of the flexible screen and improve aesthetics of the flexible screen.

A specific structure of the swing arm 20 is not limited herein. Optionally, the swing arm 20 may be a transmission gear, or the swing arm 20 may be a flexible connector.

The electronic device may be a mobile phone, a tablet personal computer (Tablet Personal Computer), a laptop computer (Laptop Computer), a personal digital assistant (Personal Digital Assistant, PDA for short), a mobile Internet device (Mobile Internet Device, MID), a wearable device (Wearable Device), or the like.

In the descriptions of this specification, reference to the description of the terms "one embodiment", "some embodiments", "example embodiment", "example", "specific example", or "some examples" means that specific features, structures, materials, or characteristics described with reference to the embodiments or examples are included in at least one embodiment or example of this application. In this specification, a schematic description of the foregoing terms does not necessarily indicate a same embodiment or example. In addition, specific features, structures, materials, or characteristics described may be incorporated in a proper manner in any one or more embodiments or examples.

Although embodiments of this application are shown and described, a person of ordinary skill in the art may understand that, various changes, modifications, replacements, and variations may be made to these embodiments without departing from the principles and objectives of this application, and the scope of this application is limited by claims and equivalents thereof.

## Claims

1. A hinge assembly, comprising a base, a swing arm, and a hinge bracket, wherein
the hinge bracket is disposed on the base, the swing arm is rotatably connected to the hinge bracket, and in a process in which the swing arm rotates relative to the hinge bracket, the hinge assembly switches between an unfolded state and a folded state; and
there is a support surface on a side that is of the hinge bracket and that is away from the base, the support surface is provided with a groove, the groove comprises a first groove part and a second groove part, the first groove part is adjacent to the swing arm, and a size of the first groove part is greater than a size of the second groove part.

2. The hinge assembly according to claim 1, wherein a width of the first groove part in a first direction is greater than a width of the second groove part in the first direction, and the first direction is a direction of a connecting line between the first groove part and the swing arm.

3. The hinge assembly according to claim 2, wherein a depth of the first groove part in a second direction is greater than a depth of the second groove part in the second direction, the second direction is a direction separately perpendicular to the first direction and a third direction, and the third direction is a direction of a connecting line between the first groove part and the second groove part.

4. The hinge assembly according to claim 1, wherein the groove further comprises a third groove part, the first groove part and the second groove part communicate with each other through the third groove part, a size of the third groove part is less than the size of the first groove part, and the size of the third groove part is greater than the size of the second groove part.

5. The hinge assembly according to claim 4, wherein the third groove part comprises a first location in communication with the first groove part and a second location in communication with the second groove part, and the size of the third groove part gradually decreases in a direction from the first location to the second location.

6. The hinge assembly according to claim 5, wherein the size of the third groove part comprises a width and a depth, the width is a width in a first direction, the first direction is a direction of a connecting line between the first groove part and the swing arm, the depth is a depth in a second direction, the second direction is a direction separately perpendicular to the first direction and a third direction, and the third direction is a direction of a connecting line between the first groove part and the second groove part.

7. The hinge assembly according to any one of claims 4 to 6, wherein a sidewall of the first groove part and a sidewall of the second groove part each are a plane, and a sidewall of the third groove part is an arc-shaped surface.

8. The hinge assembly according to any one of claims 4 to 6, wherein a first through hole for mounting a first screw is disposed in the first groove part and at a location that is of the first groove part and that is adjacent to the swing arm; and a second through hole for mounting a second screw is disposed in the third groove part and at a location that is of the third groove part and that is connected to the second groove part.

9. The hinge assembly according to any one of claims 1 to 6, wherein the first groove part comprises a first target groove part and a second target groove part that are spaced apart, and the second groove part is located between the first target groove part and the second target groove part.

10. An electronic device, comprising a flexible screen, a first housing, a second housing, and the hinge assembly according to any one of claims 1 to 9, wherein
the first housing and the second housing are respectively rotatably connected to the hinge bracket through swing arms on two sides of the hinge bracket comprised in the hinge assembly, so that the electronic device is capable of switching between an unfolded state and a folded state; and
the flexible screen is disposed on a side of the first housing and the second housing, the flexible screen comprises a bending area, the bending area is opposite to the hinge bracket, the support surface of the hinge bracket is configured to support the bending area, and the groove of the support surface is opposite to the flexible screen.

11. The electronic device according to claim 10, wherein when the electronic device is in the folded state, the first groove part is in a deformed state, and the flexible screen is closely fitted with a groove wall of the first groove part.
